# EUROPÄISCHE PATENTANMELDUNG

(11) **EP 4 843 668 A1**
(43) Veröffentlichungstag der Anmeldung: **25.11.2026**
(21) Anmeldenummer: 26178484.7
(22) Anmeldetag: 13.05.2026
(51) Int. Cl.: B01L 3/00, C03B 23/203, B81C 1/00, C03C 23/00

(54) **VERFAHREN ZUR HERSTELLUNG EINES STRUKTURIERTEN GLASARTIKELS UND GLASARTIKEL**

(30) Priorität: 21.05.2025 DE 102025119705
(71) Anmelder: SCHOTT Technical Glass Solutions GmbH, 07745 Jena (DE)
(72) Erfinder: DREISOW, Felix, 07745 Jena (DE); KUCKELKORN, Thomas, 07745 Jena (DE); KRUMBHOLZ, Marco, 07745 Jena (DE)
(74) Vertreter: Schott Corporate IP

(57) **Zusammenfassung**

Die vorliegende Offenbarung stellt ein Verfahren zur Herstellung eines strukturierten Glasbauteils bereit. Das Verfahren umfasst: Einbringen eines Tiefenprofils in ein erstes Substrat, wobei das Tiefenprofil eine erste Oberfläche des ersten Substrats strukturiert; Fügen des ersten Substrats mit einem zweiten Glassubstrat, wobei die erste Oberfläche des ersten Substrats mit einer Oberfläche des zweiten Glassubstrats in Kontakt gebracht wird; und Nachbearbeiten des ersten Substrats, um zumindest einen Teil des Tiefenprofils freizulegen.

## Beschreibung

Die Erfindung betrifft ein Verfahren zur Herstellung eines strukturierten Glasartikels, sowie einen solchen strukturierten Glasartikel.

### Stand der Technik

Mikrofluidische Vorrichtungen haben in den letzten Jahren zunehmend an Bedeutung gewonnen. Diese Vorrichtungen ermöglichen die Handhabung und Analyse sehr kleiner Flüssigkeitsmengen in Kanälen mit Abmessungen im Mikrometerbereich. Sie finden Anwendung in verschiedenen Bereichen wie der chemischen Synthese, der Bioanalytik und der medizinischen Diagnostik.

Herkömmliche Verfahren zur Herstellung mikrofluidischer Strukturen in Glas basieren häufig auf nasschemischem Ätzen oder Trockenätzverfahren. Diese Methoden haben jedoch einige Nachteile. Beim nasschemischen Ätzen ist es schwierig, präzise definierte Kanalgeometrien mit hohem Aspektverhältnis zu erzeugen. Trockenätzverfahren wie reaktives Ionenätzen ermöglichen zwar eine bessere Kontrolle der Kanalform, sind aber mit hohen Kosten verbunden und auf relativ geringe Ätztiefen beschränkt.

Ein weiterer Ansatz zur Herstellung mikrofluidischer Strukturen in Glas wird in der US-11534754-B2 beschrieben. Diese Patentschrift offenbart ein Verfahren zur Erzeugung von Mikrokanälen in Glas mittels Laserbearbeitung. Dabei wird ein Femtosekundenlaser verwendet, um zunächst eine Reihe von Löchern in das Glassubstrat zu bohren. Diese Löcher werden anschließend durch einen chemischen Ätzprozess erweitert und miteinander verbunden, wodurch ein durchgängiger Mikrokanal entsteht.

Das Verfahren ermöglicht die Herstellung von Kanälen mit hohem Aspektverhältnis und relativ glatten Oberflächen. Allerdings kann die Kombination aus Laserbohren und chemischem Ätzen zu Einschränkungen bei der Kanalgeometrie führen. Zudem kann die Oberflächenqualität der Kanalböden durch den Ätzprozess beeinträchtigt werden.

Es besteht daher weiterhin Bedarf an verbesserten Verfahren zur Herstellung mikrofluidischer Strukturen in Glas, die eine präzise Kontrolle der Kanalgeometrie bei gleichzeitig hoher Oberflächenqualität ermöglichen.

Ein weiteres Problem bei konventionellen Herstellungsverfahren ist die Oberflächenrauheit der erzeugten Kanalstrukturen. Insbesondere die Bodenflächen der Kanäle weisen oft eine erhöhte Rauheit auf, was zu unerwünschten Effekten bei der Flüssigkeitsströmung führen kann. Zudem ist es schwierig, die Oberflächenqualität der Kanalböden nachträglich zu verbessern, ohne die Seitenwände zu beeinflussen.

Es wurde erkannt, dass ein Verfahren benötigt wird, das diese Probleme überwindet.

Diese Aufgabe wird mit dem Verfahren nach Anspruch 1 gelöst. Vorteilhafte Ausgestaltungen sind Gegenstand der abhängigen Ansprüche.

### Offenbarung der Erfindung

Diese Zusammenfassung dient dazu, eine Auswahl von Konzepten in vereinfachter Form vorzustellen, die im Folgenden in der ausführlichen Beschreibung näher erläutert werden.

In einem ersten Aspekt wird ein Verfahren zur Herstellung eines strukturierten Glasartikels mit wenigstens einer die Struktur bildenden einseitig offenen Vertiefung bereitgestellt. Das Verfahren umfasst: Vorstrukturieren eines ersten Substrats aus Glas, sodass in dem Substrat ein Tiefenprofil ausgebildet wird, das sich von einer ersten Oberfläche des Substrats in Richtung einer zweiten Oberfläche des Substrats erstreckt, stoffschlüssiges Verbinden der ersten Oberfläche des ersten Substrats mit einer Oberfläche eines zweiten Substrats, wobei die Oberfläche des zweiten Substrats wenigstens in demjenigen Bereich, der mit dem Tiefenprofil in der ersten Oberfläche des ersten Substrats überlappt, einen quadratischen Mittenrauwert Rq von < 5 nm aufweist, und Nachbearbeiten des ersten Substrats zur Erzeugung der wenigstens einen Vertiefung, sodass die Bodenfläche der Vertiefung durch die Oberfläche des zweiten Substrats gebildet wird.

Dieses Verfahren ermöglicht die Herstellung von strukturierten Glasartikeln mit präzise definierten Vertiefungen und extrem glatten Bodenflächen, wobei die Vertiefungen im Weiteren als mikrofluidische Kanäle eingesetzt werden können. Durch die Verwendung eines zweiten Substrats mit sehr geringer Oberflächenrauheit als Bodenfläche der Vertiefungen können mikrofluidische Strukturen mit hervorragenden optischen und strömungstechnischen Eigenschaften erzeugt werden. Dabei wird die Qualität der Bodenflächen einzig durch die Oberflächenqualität des zweiten Substrats bestimmt.

Der quadratische Mittenrauwert Rq ist dabei ein Oberflächenrauheitsparameter, der die Standardabweichung der Höhenverteilung einer Oberfläche beschreibt. Er kann als ein Maß für die durchschnittliche Abweichung des Oberflächenprofils von einer idealen glatten Oberfläche betrachtet werden.

Zur Berechnung von Rq kann folgende Formel verwendet werden: $Rq = \sqrt{\frac{1}{n} {\sum }_{i = 1}^{n} {y}_{i}^{2}}$

Dabei gilt:
- n ist die Anzahl der Messpunkte entlang der Oberfläche
- yᵢ ist die vertikale Abweichung des i-ten Messpunkts von der mittleren Linie des Profils

In der Praxis wird Rq häufig durch Abtasten der Oberfläche mit einem Profilometer oder durch optische Messverfahren bestimmt. Der resultierende Wert gibt Aufschluss über die Oberflächengüte und kann in verschiedenen Einheiten, typischerweise Nanometer (nm) oder Mikrometer (µm), angegeben werden.

Das stoffschlüssige Verbinden der Substrate kann auf verschiedene Arten erfolgen:
In einigen Ausführungsformen kann das stoffschlüssige Verbinden durch direktes Bonden der Glassubstrate durchgeführt werden. Dabei werden die zu verbindenden Oberflächen zunächst gründlich gereinigt und aktiviert, beispielsweise durch Plasmabehandlung. Anschließend werden die Substrate unter Druck und erhöhter Temperatur zusammengepresst, wodurch eine feste Verbindung auf atomarer Ebene entsteht.

In anderen Fällen kann das Verbinden durch Fusion Bonding erfolgen. Hierbei werden die Substrate auf eine Temperatur nahe dem Erweichungspunkt des Glases erhitzt und unter Druck zusammengefügt. Durch lokales Aufschmelzen der Grenzflächen entsteht eine homogene Verbindung.

Eine weitere Möglichkeit ist das anodische Bonden. Bei diesem Verfahren wird eine Spannung zwischen den Substraten angelegt, während sie erhitzt werden. Dies führt zur Migration von Ionen an der Grenzfläche und ermöglicht eine feste Verbindung auch zwischen unterschiedlichen Materialien wie Glas und Silizium.

In manchen Ausführungsformen kann auch ein Zwischenschichtbonden angewendet werden. Dabei wird eine dünne Schicht eines Bonding-Materials, wie beispielsweise ein niedrigschmelzendes Glas oder ein Polymer, zwischen den Substraten aufgebracht. Durch Erhitzen und Pressen wird diese Zwischenschicht aktiviert und verbindet die Substrate.

Das Laserbonden stellt eine weitere Option dar. Hierbei wird ein Laser verwendet, um die Grenzfläche lokal zu erhitzen und eine Verbindung herzustellen. Diese Methode ermöglicht eine sehr präzise und lokalisierte Verbindung der Substrate.

In einigen Fällen kann auch ein adhäsives Bonden mit speziellen optischen Klebstoffen eingesetzt werden. Diese Methode erlaubt das Verbinden bei niedrigeren Temperaturen, was vorteilhaft für temperaturempfindliche Komponenten sein kann.

Die Wahl des geeigneten Bondingverfahrens kann von verschiedenen Faktoren abhängen, wie den spezifischen Materialeigenschaften der Substrate, den gewünschten Eigenschaften der Verbindung, den Prozesstemperaturen und den Anforderungen der späteren Anwendung.

In einigen Ausführungsformen können die Substrate aus Borosilikatglas bestehen. Borosilikatglas kann aufgrund seiner vorteilhaften Eigenschaften wie hoher chemischer Beständigkeit, geringer thermischer Ausdehnung und guter optischer Transparenz für die Herstellung mikrofluidischer Strukturen geeignet sein. Die Verwendung von Borosilikatglas als Substratmaterial kann die Kompatibilität mit verschiedenen Bondingverfahren und Nachbearbeitungsschritten verbessern und gleichzeitig die gewünschten Eigenschaften des fertigen strukturierten Glasartikels gewährleisten.

In einigen Ausführungsformen kann als Borosilikatglas beispielsweise BOROFLOAT^{®} 33 von Schott verwendet werden. Dieses Glas weist eine Zusammensetzung auf, die typischerweise etwa 80,6% SiO₂, 12,6% B₂O₃, 4,2% Na₂O und 2,2% Al₂O₃ enthält. Diese Zusammensetzung kann dem Glas vorteilhafte Eigenschaften wie eine hohe chemische Beständigkeit, einen niedrigen thermischen Ausdehnungskoeffizienten und eine gute optische Transparenz verleihen. Die genauen Prozentanteile der Bestandteile können in gewissen Grenzen variieren, ohne die charakteristischen Eigenschaften des Borosilikatglases wesentlich zu beeinflussen. Die Verwendung eines solchen Borosilikatglases als Substratmaterial kann in manchen Fällen die Herstellung von mikrofluidischen Strukturen mit den gewünschten optischen, thermischen und chemischen Eigenschaften erleichtern.

Das erste Substrat weist nach einer Ausführungsform eine Dicke D auf, wobei sich das Tiefenprofil höchstens bis in eine Tiefe d1 in das Substrat hinein erstreckt, wobei d1 < D gilt. Das Tiefenprofil durchdringt demnach das erste Substrat nicht vollständig.

Diese Konfiguration ermöglicht eine präzise Kontrolle der Tiefe der erzeugten Vertiefungen und verhindert ein unbeabsichtigtes Durchbohren des ersten Substrats während des Vorstrukturierens.

Nach einer alternativen Ausführungsform kann sich das Tiefenprofil in einem ersten Teilbereich bis in eine Tiefe d1 in das erste Substrat hinein erstrecken, wobei d1 < D gilt, und sich in einem zweiten Teilbereich vollständig durch das Substrat erstrecken.

Diese Variante erlaubt die Herstellung komplexerer Strukturen mit unterschiedlichen Tiefen und durchgehenden Öffnungen in einem einzigen Fertigungsschritt. So können beispielsweise isolierte Inseln in der fertigen Struktur erzeugt werden. Durch diejenigen Bereiche, in denen das Tiefenprofil das Substrat nicht vollständig durchdringt können dabei Stege realisiert sein, die die Inseln in dem ersten Substrat bis zur Verbindung mit dem zweiten Substrat in ihrer Anordnung gegenüber den übrigen Bereichen des Tiefenprofils lokalisieren.

Das Nachbearbeiten des ersten Substrats kann nach einer weiteren Ausführungsform das Abtragen von Material von dem ersten Substrat über eine Dicke d2 von der zweiten Oberfläche ausgehend beinhalten, wobei d2 > D - d1 gilt.

Durch diese Nachbearbeitung wird sichergestellt, dass die vorstrukturierten Bereiche des Tiefenprofils vollständig freigelegt werden und die gewünschte Vertiefungsgeometrie und mithin die gewünschte Geometrie der mikrofluidischen Kanäle entsteht.

Das Nachbearbeiten des ersten Substrats kann durch verschiedene Verfahren erfolgen. In einigen Ausführungsformen kann das Nachbearbeiten durch Schleifen durchgeführt werden, wobei abrasive Partikel verwendet werden, um Material von der Oberfläche abzutragen. In anderen Fällen kann ein Läppverfahren eingesetzt werden, das eine besonders hohe Oberflächengüte ermöglicht. Polieren kann ebenfalls als Nachbearbeitungsmethode dienen, um eine sehr glatte Oberfläche zu erzielen. In manchen Ausführungsformen kann das Nachbearbeiten auch durch Fräsen erfolgen, was eine präzise Kontrolle der abzutragenden Materialmenge erlaubt. Die Wahl des geeigneten Nachbearbeitungsverfahrens kann von Faktoren wie der gewünschten Oberflächenqualität, der Materialzusammensetzung des Substrats und den spezifischen Anforderungen der Anwendung abhängen. Dabei können auch mehrere der vorstehend genannten Methoden kombiniert zum Einsatz kommen.

Vor dem Abtragen von Material von dem ersten Substrat kann nach einer weiteren Ausführungsform wenigstens ein Abstandshalter auf die dem ersten Substrat zugewandte Oberfläche des zweiten Substrats im Bereich des Tiefenprofils aufgebracht werden, wobei der Abstandshalter eine Dicke d3 = D - d2 aufweist und wobei der Abstandshalter aus einem Material besteht, dessen Härte größer ist als die Härte des ersten Substrats.

Die Verwendung eines harten Abstandshalters ermöglicht eine präzise Kontrolle der Abtragtiefe während der Nachbearbeitung und verhindert ein übermäßiges Abtragen des Materials.

Der Abstandshalter kann durch seine höhere Härte im Vergleich zum Substratmaterial als Begrenzung für den Materialabtrag dienen.

Während des Nachbearbeitungsprozesses kann das Abtragsverfahren, sei es Schleifen, Läppen oder eine andere Methode, bis zum Erreichen des härteren Abstandshalters fortgesetzt werden. Sobald das Abtragsverfahren auf den Abstandshalter trifft, kann es aufgrund dessen höherer Widerstandsfähigkeit gegen Abrieb nicht weiter in die Tiefe vordringen. Auf diese Weise kann der Abstandshalter eine definierte Endtiefe für den Materialabtrag vorgeben und somit eine präzise Kontrolle der resultierenden Strukturtiefe ermöglichen.

Das Tiefenprofil kann dabei nach einer Ausführungsform durch Laserablation erzeugt werden.

Laserablation ermöglicht die Erzeugung sehr feiner und präziser Strukturen mit hoher Reproduzierbarkeit. Dies ist insbesondere vorteilhaft, wenn komplexe Geometrien der Kanalverläufe realisiert werden sollen.

Nach einer alternativen Ausführungsform kann das Tiefenprofil durch spanende Bearbeitung des ersten Substrats erzeugt werden.

Spanende Bearbeitung ist besonders geeignet für die Herstellung größerer Strukturen und ermöglicht eine hohe Materialabtragsrate. Beispielhaft kann CNC-Fräsen als spanende Bearbeitungsmethode dienen . CNC-Fräsen ermöglicht eine hohe Präzision und Reproduzierbarkeit bei der Herstellung von Strukturen in Glassubstraten. Durch die computergesteuerte Bearbeitung können komplexe Geometrien mit hoher Genauigkeit realisiert werden. Die Flexibilität des CNC-Fräsens erlaubt zudem eine einfache Anpassung der Strukturgeometrien ohne aufwendige Werkzeugwechsel. In einigen Fällen kann CNC-Fräsen auch eine höhere Bearbeitungsgeschwindigkeit im Vergleich zu anderen spanenden Verfahren bieten, was die Effizienz des Herstellungsprozesses steigern kann. Die Oberflächenqualität der erzeugten Strukturen kann durch die Wahl geeigneter Fräsparameter und Werkzeuge optimiert werden.

Das Tiefenprofil kann auch durch Einbringen von Filamenten in den Glaskörper des ersten Substrats und eine anschließende Verbreiterung der Filamente senkrecht zur Erstreckungsrichtung der Filamente erzeugt werden. Dabei erstecken sich die Filamente bevorzugt nicht vollständig durch die Dicke D des ersten Substrats.

Diese Methode ermöglicht die Erzeugung von Strukturen mit sehr hohem Aspektverhältnis und ist besonders geeignet für die Herstellung von Mikrokanälen. Dabei können insbesondere sehr grade Kanten und Seitenwände der erzeugten Kanalstrukturen realisiert werden.

Die Verbreiterung der Filamente kann insbesondere durch Ätzverfahren erfolgen. Bei diesem Prozess können chemische oder physikalische Ätzmethoden eingesetzt werden, um das Glasmaterial um die Filamente herum kontrolliert abzutragen. Durch die Wahl geeigneter Ätzparameter wie Ätzmittelkonzentration, Temperatur und Ätzdauer kann die Verbreiterung präzise gesteuert werden. Dies ermöglicht eine gezielte Anpassung der Kanalgeometrie und des Querschnitts. Nasschemisches Ätzen mit Flusssäure oder Trockenätzverfahren wie reaktives Ionenätzen können dabei zum Einsatz kommen. Die Ätzverfahren können eine gleichmäßige Verbreiterung der Filamente bewirken und so zur Erzeugung von Kanälen mit glatten Seitenwänden und definierten Querschnitten beitragen.

Nach einer Ausführungsform kann sich das Tiefenprofil durch das Substrat hindurch erstrecken, wobei das Tiefenprofil in der Oberfläche des Substrats keine geschlossene Kurve bildet, die einen Teilbereich der Oberfläche vollständig einschließt.

Diese Konfiguration, bei der das Tiefenprofil keine geschlossene Kurve in der Oberfläche des Substrats bildet, kann vorteilhaft sein, um die strukturelle Integrität des ersten Substrats während des Herstellungsprozesses zu erhalten. Indem vermieden wird, dass das Tiefenprofil einen Teilbereich der Oberfläche vollständig umschließt, kann verhindert werden, dass einzelne Elemente oder Bereiche des ersten Substrats vor der Verbindung mit dem zweiten Substrat herausfallen oder sich lösen.

Diese Anordnung kann dazu beitragen, die Stabilität und Handhabbarkeit des ersten Substrats zu verbessern, bevor es mit dem zweiten Substrat stoffschlüssig verbunden wird. Dadurch kann die Präzision und Zuverlässigkeit des Herstellungsprozesses erhöht werden, da alle strukturierten Bereiche des ersten Substrats in ihrer vorgesehenen Position verbleiben.

In einigen Fällen kann diese Konfiguration auch die Flexibilität bei der Gestaltung der Kanalgeometrien erhöhen, da komplexe, miteinander verbundene Strukturen realisiert werden können, ohne dass isolierte Bereiche entstehen, die möglicherweise instabil wären oder verloren gehen könnten.

Das Nachbearbeiten des ersten Substrats beinhaltet nach einer Ausführungsform das Erhöhen der Ausdehnung des Tiefenprofils in Erstreckungsrichtung des Substrats.

Durch diese Nachbearbeitung können die initial erzeugten Strukturen erweitert und miteinander verbunden werden, was die Herstellung komplexerer Kanalgeometrien ermöglicht.

Dementsprechend kann das Nachbearbeiten des ersten Substrats in einigen Ausführungsformen das Vervollständigen von zuvor nicht geschlossenen Kurven des Tiefenprofils beinhalten. Durch diesen Prozess können Bereiche, die zunächst noch mit dem Hauptkörper des ersten Substrats verbunden waren, vollständig isoliert werden.

Diese Methode kann es ermöglichen, dass bestimmte Elemente oder Strukturen aus dem ersten Substrat herausgelöst werden. Dabei kann das Nachbearbeiten so durchgeführt werden, dass die zuvor offenen Enden des Tiefenprofils miteinander verbunden werden, wodurch eine geschlossene Kontur entsteht.

In manchen Fällen kann dies dazu führen, dass einzelne Bereiche des ersten Substrats vollständig vom Rest des Materials getrennt werden. Diese isolierten Elemente können dann aus dem Substrat entfernt werden, was zur Erzeugung komplexer dreidimensionaler Strukturen oder freiliegender Komponenten innerhalb des Glasartikels beitragen kann.

Dieser Ansatz kann die Flexibilität des Herstellungsverfahrens erweitern und die Möglichkeit bieten, Strukturen zu erzeugen, die mit anderen Methoden schwer zu realisieren wären. Die gezielte Isolierung und Entfernung bestimmter Bereiche kann für spezielle Anwendungen in der Mikrofluidik oder anderen Bereichen, die präzise strukturierte Glaskomponenten erfordern, von Vorteil sein.

Das Erhöhen der Ausdehnung des Tiefenprofils kann beispielsweise durch einen Ätzprozess erfolgen. Bei diesem Verfahren kann ein chemisches oder physikalisches Ätzmittel verwendet werden, um kontrolliert Material von den Wänden und dem Boden des Tiefenprofils abzutragen. Durch die Wahl geeigneter Ätzparameter wie Ätzmittelkonzentration, Temperatur und Ätzdauer kann die Erweiterung des Profils präzise gesteuert werden.

In einigen Fällen kann ein isotropes Ätzen eingesetzt werden, bei dem das Material gleichmäßig in alle Richtungen abgetragen wird. Dies kann zu einer Verbreiterung und Vertiefung des Profils führen. In anderen Fällen kann ein anisotropes Ätzverfahren verwendet werden, um die Ausdehnung des Profils in bestimmten Richtungen bevorzugt zu erhöhen.

Die Verwendung von Ätzmasken kann es ermöglichen, bestimmte Bereiche des Tiefenprofils selektiv zu erweitern, während andere Bereiche geschützt bleiben. Dies kann zur Erzeugung komplexer Geometrien und variabler Querschnitte innerhalb des Profils beitragen.

Nach einer weiteren Ausführungsform ist vorgesehen, dass das Tiefenprofil aus Filamenten besteht, wobei die Filamente nicht miteinander überlappen.

In diesem Zusammenhang bezeichnet der Begriff "Filament" eine längliche, fadenförmige Struktur, die in das Glassubstrat eingebracht wird. Diese Filamente können durch gezielte Laserbestrahlung erzeugt werden, wobei der Laser eine lokale Modifikation des Glasmaterials bewirkt. Die Filamente können sich durch veränderte optische, chemische oder physikalische Eigenschaften von dem umgebenden Glasmaterial unterscheiden. Sie können als Ausgangspunkt für die Erzeugung von Kanälen oder anderen Strukturen im Glas dienen, indem sie beispielsweise durch nachfolgende Ätzprozesse selektiv verbreitert oder entfernt werden.

Diese Anordnung ermöglicht eine präzise Kontrolle der Strukturgeometrie und verhindert unerwünschte Wechselwirkungen zwischen benachbarten Filamenten während des Strukturierungsprozesses.

Die Filamente können dabei nach einer weiteren Ausführungsform entlang einer Konturlinie angeordnet sein, wobei das Nachbearbeiten das Erhöhen des Durchmessers der Filamente beinhaltet, sodass sich benachbarte Filamente zu einem durchgehenden Schnittspalt verbinden, der sich entlang der Konturlinie erstreckt.

Diese Methode ermöglicht die Herstellung von durchgehenden Schnittspalten mit präzise definierten Geometrien und glatten Seitenwänden, die ein Herauslösen definierter Bereiche aus dem ersten Substrat ermöglichen.

Alternativ können die Filamente in einer Teilfläche der Oberfläche des Substrats in einem regelmäßigen oder unregelmäßigen Muster flächig eingebracht werden, wobei das Nachbearbeiten das Erhöhen des Durchmessers der Filamente beinhaltet, sodass sich benachbarte Filamente zu einer flächigen Ausnehmung aus dem ersten Substrat verbinden.

Diese Variante ermöglicht die Herstellung von großflächigen Vertiefungen oder Kammern mit sehr glatten Bodenflächen und präzise definierten Rändern.

Nach dem Vorstrukturieren des ersten Substrats und vor dem Verbinden der ersten Oberfläche des ersten Substrats mit der Oberfläche des zweiten Substrats können definierte Bereiche der ersten Oberfläche des ersten Substrats so bearbeitet werden, dass ein stoffschlüssiges Verbinden des ersten Substrats mit dem zweiten Substrat in den definierten Bereichen verhindert wird.

Diese selektive Bearbeitung ermöglicht die gezielte Kontrolle des Bondingprozesses und die Erzeugung von nicht gebondeten Bereichen. Nach der Verbreiterung des Tiefenprofils durch den Nachbearbeitungsprozess können bestimmte Bereiche des ersten Substrats vollständig vom Rest des Materials isoliert werden. Diese isolierten Elemente sind dann weder mit dem Hauptkörper des ersten Substrats noch mit dem zweiten Substrat verbunden. Aufgrund der fehlenden Verbindung fallen diese isolierten Bereiche aus der Struktur heraus. Dieser Vorgang markiert den Abschluss der Kanalbildung, da die nun freiliegenden Räume die gewünschten Kanäle oder Hohlräume in der Glasstruktur darstellen. Die präzise Kontrolle dieses Prozesses ermöglicht die Herstellung komplexer dreidimensionaler Strukturen innerhalb des Glasartikels, die für spezifische Anwendungen in der Mikrofluidik oder anderen Bereichen, die strukturierte Glaskomponenten erfordern, von großem Nutzen sein können.

Das stoffschlüssige Verbinden kann durch verschiedene Methoden beeinflusst werden. In einigen Fällen kann ein gezieltes Aufrauen bestimmter Bereiche der ersten Oberfläche des ersten Substrats eingesetzt werden. Dies kann die Haftung in diesen Bereichen verringern. Alternativ kann eine Beschichtung auf ausgewählte Bereiche des ersten Substrats aufgebracht werden, um das Bonden lokal zu verhindern. In anderen Ausführungsformen kann die Dicke des ersten Substrats in definierten Bereichen reduziert werden. Dies kann durch selektives Ätzen oder mechanisches Abtragen erreicht werden. Die reduzierte Materialstärke in diesen Bereichen kann dazu führen, dass beim Nachbearbeiten des Substrats diese Bereiche vollständig entfernt werden und somit keine Verbindung zum zweiten Substrat aufweisen. Diese Methoden ermöglichen eine präzise Kontrolle darüber, welche Bereiche des ersten Substrats mit dem zweiten Substrat verbunden werden und welche nicht.

In einem zweiten Aspekt wird ein strukturierter Glasartikel bereitgestellt, der nach dem Verfahren gemäß einem der vorhergehenden Aspekte hergestellt ist.

Der nach diesem Verfahren hergestellte strukturierte Glasartikel weist eine einzigartige Kombination aus präzise definierten Vertiefungen und extrem glatten Bodenflächen auf, was ihn besonders geeignet für mikrofluidische und optische Anwendungen macht.

Nach einer Ausführungsform ist dabei vorgesehen, dass die Seitenwände des Tiefenprofils in dem ersten Substrat eine Rauheit Rq von mehr als 100 nm aufweisen.

Die Erfindung soll nachfolgend anhand der Figuren und ohne Beschränkung hierauf eingehender beschrieben werden. Gleiche Bezugszeichen bezeichnen dabei gleiche oder ähnliche Elemente.

Es zeigen:
Fig. 1 zeigt Querschnittsansichten von strukturierten Glaskomponenten nach dem Stand der Technik.
Fig. 2 veranschaulicht Querschnittsansichten eines Herstellungsprozesses für eine strukturierte Glaskomponente, gemäß einem Aspekt der Erfindung.
Fig. 3 stellt Querschnittsansichten von Methoden zur Erzeugung eines Tiefenprofils in einem Glassubstrat dar, gemäß Ausführungsformen der Erfindung.
Fig. 4 illustriert Querschnittsansichten eines weiteren Prozesses zur Erzeugung eines Tiefenprofils mittels Filamenten, gemäß einem Aspekt der vorliegenden Erfindung.
Fig. 5 zeigt orthogonale Ansichten einer strukturierten Glaskomponente mit einer Insel, gemäß einer Ausführungsform der Erfindung.
Fig. 6 veranschaulicht Querschnittsansichten eines Herstellungsprozesses für eine strukturierte Glaskomponente mit Abstandshaltern, gemäß einem Aspekt der Erfindung.
Fig. 7 stellt Querschnittsansichten eines Prozesses zur Erzeugung von lösbaren Segmenten in einer Glaskomponente dar, gemäß Ausführungsformen der vorliegenden Erfindung.
Fig. 8 zeigt Draufsichten einer strukturierten Glaskomponente nach Fig. 7 vor und nach einem Ätzprozess, gemäß einem Aspekt der Erfindung.
Fig. 9 illustriert Querschnittsansichten eines Herstellungsprozesses für eine strukturierte Glaskomponente mit Filamenten, gemäß einer Ausführungsform der Erfindung.

In allen Abbildungen werden gleiche Bezugszeichen verwendet, um ähnliche Merkmale anzuzeigen.

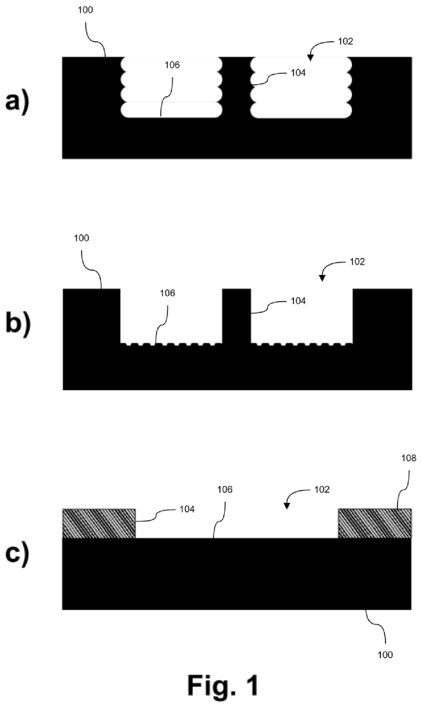

Fig. 1 zeigt drei Querschnittsansichten von strukturierten Glaskomponenten, die verschiedene Methoden des Standes der Technik zur Herstellung von mikrofluidischen Kanälen in einem Glassubstrat darstellen.

In Fig. 1a ist ein Glassubstrat 100 mit zwei vertieften Bereichen dargestellt, die Kanäle 102 bilden. Die Kanäle 102 werden durch Seitenwände 104 und eine Bodenfläche 106 begrenzt. Die Kanäle 102 wurden durch ein Ätzverfahren, wie beispielsweise tiefes reaktives Ionenätzen (DRIE) erzeugt, was zu einer ungleichmäßigen Struktur der Seitenwände führt, da diese durch das Ätzverfahren angegriffen werden. Dieses Verfahren erfordert zudem zusätzliche Maskierungs- und Demaskierungsschritte, was die Prozesszeit erhöht. Tiefe Strukturen sind zudem nur mit langwierigen Prozessen aufgrund des langsam verlaufenden Ätzvorgangs realisierbar.

Fig. 1b zeigt ein Glassubstrat 100 mit Kanälen 102, die durch Laserablation erzeugt wurden. Dieses Verfahren führt jedoch zu einer unebenen Oberflächenstruktur an der Bodenfläche 106 der Kanäle 102, die mit Rauheitswerten zwischen 100 nm und 2 µm rms einhergehen kann.

In Fig. 1c wird eine dritte Methode dargestellt, bei der ein strukturiertes zweites Glassubstrat 108 auf die Oberfläche des Glassubstrats 100 gebondet wird, um den Kanal 102 zu erzeugen. Dieses Verfahren ist hinsichtlich der möglichen Kanalgeometrien eingeschränkt, da beispielsweise isolierte Elemente nicht ordnungsgemäß auf dem Glassubstrat 100 platziert werden können, sodass definierte Geometrien nur schwer eingehalten werden können. Zudem ist dieses Verfahren insbesondere durch die problematische Handhabung des zweiten Glassubstrats 108 bei Dicken von weniger als 100 µm limitiert.

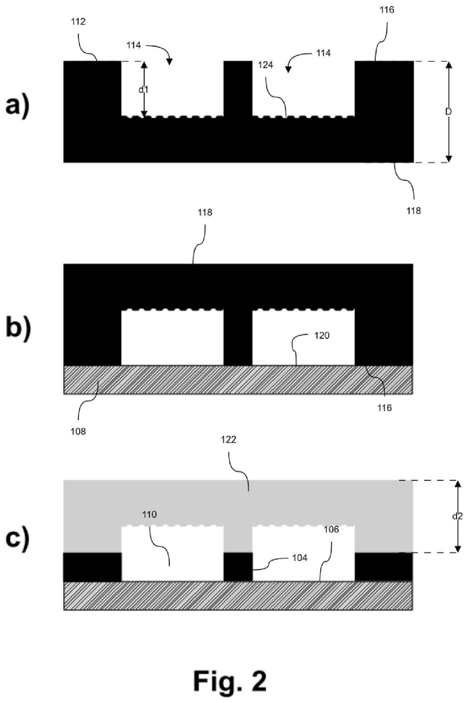

Die vorliegende Erfindung stellt demgegenüber ein verbessertes Verfahren zur Herstellung strukturierter Glasartikel vor, das diese Nachteile überwindet. Fig. 2 veranschaulicht die Hauptschritte einer Ausführungsform des erfindungsgemäßen Verfahrens.

Zunächst wird, wie in Fig. 2a gezeigt, ein Tiefenprofil 114 in einem ersten Substrat 112 erzeugt. Mögliche Methoden zur Erzeugung des Tiefenprofils 114 werden im Folgenden mit Bezug auf weitere Figuren erläutert. Das erste Substrat 112 weist dabei eine erste Oberfläche 116 und eine zweite Oberfläche 118 auf. Die Tiefe des Profils wird als Profiltiefe d1 bezeichnet. Die Oberflächenbeschaffenheit bzw. Oberfrlächengüte der Bodenfläche 124 des so erzeugten Tiefenprofils 114 ist dabei nicht relevant und kann durchaus beispielsweise eine Rauheit im Mikrometerbereich aufweisen.

Im nächsten Schritt, dargestellt in Fig. 2b, wird das erste Substrat 112 mit einem zweiten Glassubstrat 108 entlang seiner ersten Oberfläche 116 verbunden. Die Oberfläche 120 des zweiten Glassubstrats 108, die mit dem ersten Substrat 112 in Kontakt steht, erzeugt somit einen glatten Boden für die eingeschlossenen Kanäle, die durch das Tiefenprofil 114 definiert wurden.

Schließlich wird, wie in Fig. 2c gezeigt, ein Materialabtrag 122 ausgehend von der zweiten Oberfläche 118 des ersten Substrats 112 durchgeführt. Dieser Schritt legt die zuvor eingeschlossenen Kanäle des Tiefenprofils 114 frei und erzeugt offene Vertiefungen 110 in der Glasstruktur. Die Tiefe des Materialabtrags wird als Materialabtragstiefe d2 bezeichnet. Die offenen Vertiefungen 110 können anschließend durch weiteres Verbinden des so erzeugten Glasartikels mit einem weiteren Glassubstrat als mikrofluidische Kanäle genutzt werden.

Das resultierende strukturierte Glasbauteil weist dabei im Bereich der Vertiefungen 110 eine Bodenfläche 106 auf, die durch das zweite Glassubstrat 108 gebildet wird, sowie Seitenwände 104, die durch das verbleibende Material des ersten Substrats 112 gebildet werden.

Die Tiefe des Kanals 102 kann von Mikrometern bis zu Millimetern reichen. Die Bodenfläche 106 kann eine Oberflächenrauheit von <1nm rms, maximal 5nm aufweisen, wobei die Oberflächengüte der Bodenfläche einzig durch die Oberflächengüte des zweiten Substrats 108 definiert wird.

Es ist zu beachten, dass die Profiltiefe d1 größer oder gleich der Materialabtragstiefe d2 sein kann, was eine präzise Kontrolle der endgültigen Kanalgeometrie ermöglicht.

Dieses Verfahren ermöglicht die Herstellung von strukturierten Glaskomponenten mit präzise geformten internen Kanälen und komplexen Geometrien bei gleichzeitig hoher Güte der Bodenflächen der Kanäle, die für Anwendungen wie Mikrofluidik oder andere spezialisierte Glasprodukte, die komplizierte interne Strukturen erfordern, besonders nützlich sein können.

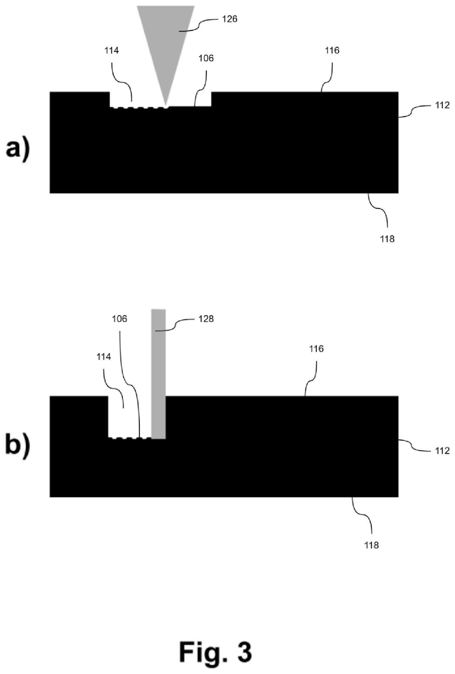

Zur Herstellung des Tiefenprofils 114 in dem ersten Substrat 112 können verschiedene Methoden angewendet werden. Fig. 3 zeigt zwei mögliche Verfahren zur Erzeugung eines Tiefenprofils 114.

In Fig. 3a ist ein erstes Substrat 112 mit einer ersten Oberfläche 116 und einer zweiten Oberfläche 118 dargestellt. Ein Laser 126 wird verwendet, um ein Tiefenprofil 114 durch Laserablation in der ersten Oberfläche 116 des ersten Substrats 112 zu erzeugen. Die Laserablation ermöglicht eine präzise und kontrollierte Abtragung des Materials zur Formung des Tiefenprofils 114.

Fig. 3b zeigt eine alternative Methode zur Erzeugung des Tiefenprofils 114. Hier wird ein Fräskopf 128 eingesetzt, um das Tiefenprofil 114 durch mechanisches Fräsen in der ersten Oberfläche 116 des ersten Substrats 112 zu erzeugen. Das mechanische Fräsen kann für größere Strukturen oder bei bestimmten Materialien vorteilhaft sein.

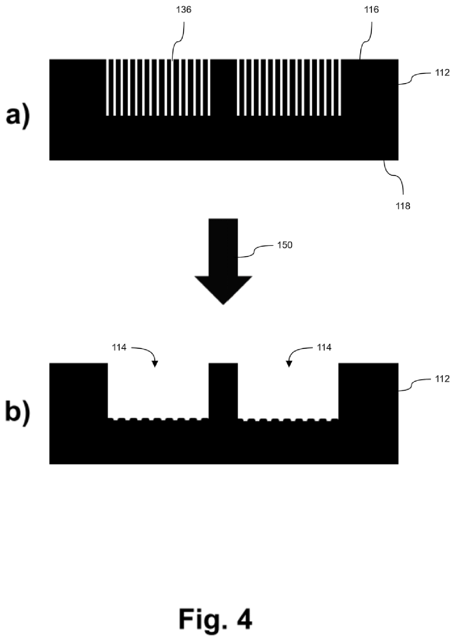

Eine weitere Methode zur Erzeugung des Tiefenprofils ist in Fig. 4 dargestellt. Fig. 4a zeigt ein erstes Substrat 112 mit einer ersten Oberfläche 116 und einer zweiten Oberfläche 118. In diesem Fall werden Filamente 136 im ersten Substrat 112 ausgehend von der ersten Oberfläche 116 erzeugt. Diese Filamente 136 können beispielsweise durch Laserbearbeitung entstehen.

Anschließend wird das erste Substrat 112 einem Ätzprozess 150 unterzogen, dessen Ergebnis in Fig. 4b dargestellt ist. Durch diesen Ätzprozess 150 werden die Bereiche um die Filamente 136 herum abgetragen und die Filamente 136 in ihrem Durchmesser verbreitert, wodurch das gewünschte Tiefenprofil 114 entsteht.

Jede dieser Methoden zur Erzeugung des Tiefenprofils 114 hat spezifische Vor- und Nachteile. Die Laserablation ermöglicht eine sehr präzise Bearbeitung und ist besonders für feine Strukturen geeignet. Das mechanische Fräsen kann für größere Strukturen oder bei bestimmten Materialien vorteilhaft sein. Die Methode der Filamenterzeugung mit anschließendem Ätzen kann besonders gleichmäßige und glatte Oberflächen im Tiefenprofil 114 erzeugen.

Die Wahl der Methode zur Erzeugung des Tiefenprofils 114 kann von verschiedenen Faktoren abhängen, wie der gewünschten Geometrie, dem verwendeten Material des ersten Substrats 112 und den spezifischen Anforderungen an die Oberflächenbeschaffenheit der Bodenfläche 106 des resultierenden Kanals.

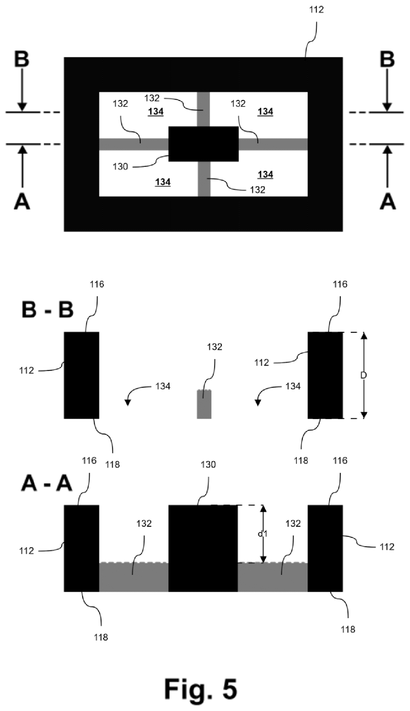

Fig. 5 zeigt zwei orthogonale Ansichten eines strukturierten Glasbauteils, die als Draufsicht und Querschnittsansicht B-B bzw. A-A gekennzeichnet sind.

Die Draufsicht zeigt ein erstes Substrat 112 mit einem rechteckigen Umriss. Innerhalb dieses Substrats befindet sich eine zentrale rechteckige Struktur, die als Insel 130 bezeichnet wird. Die Insel 130 ist von einem kanalartigen Bereich umgeben, der in einen ersten Teilbereich 132 und einen zweiten Teilbereich 134 unterteilt ist. Der erste Teilbereich 132 erscheint als hellgraue Bereiche neben der Insel 130 und stellt Brücken dar, die die Insel 130 mit dem verbleibenden ersten Substrat 112 verbinden. Die Brücken im ersten Teilbereich 132 können durch Entfernen des Materials des ersten Substrats 112 nur bis zu einer Tiefe d1 erzeugt werden, die geringer ist als die Gesamtdicke D des Substrats 112. Der zweite Teilbereich 134 wird durch weiße Bereiche dargestellt, die sich bis zu den Rändern des ersten Substrats 112 erstrecken und Bereiche repräsentieren, in denen das Material des ersten Substrats 112 vollständig entfernt wurde.

Die Querschnittsansicht B-B bietet eine Seitenansicht der Struktur entlang der Linie B-B. Sie zeigt das erste Substrat 112 als einen festen Block mit dem ersten Teilbereich 132 in der Mitte. Zu beiden Seiten des ersten Teilbereichs 132, der als Brücke verstanden werden kann, die die Insel 130 mit dem verbleibenden ersten Substrat 112 verbindet, befinden sich vertiefte Bereiche, die dem zweiten Teilbereich 134 entsprechen, in dem das Material des ersten Substrats 112 vollständig entfernt wurde.

Die Querschnittsansicht A-A präsentiert eine weitere Perspektive der Struktur entlang der Linie A-A, die durch die Insel 130 schneidet. Sie zeigt das erste Substrat 112 mit abwechselnden erhöhten und vertieften Abschnitten. Die erhöhten Abschnitte entsprechen der Insel 130 und den Rändern des ersten Substrats 112, während die vertieften Abschnitte den ersten Teilbereich 132 darstellen. Die Tiefe dieser vertieften Abschnitte wird als d1 bezeichnet und gibt die Profiltiefe der Struktur an.

Die Insel 130 ist über Brücken mit dem Glaskörper verbunden , die durch den ersten Teilbereich 132 gebildet werden. Diese Konfiguration ermöglicht die Bildung komplexer interner Geometrien innerhalb des Glases, die für Anwendungen wie Mikrofluidik oder andere spezialisierte Glasprodukte, die komplexe interne Strukturen erfordern, besonders nützlich sein können, da die Insel 130 durch die in den ersten Teilbereichen 132 ausgebildeten Brücken fest mit dem ersten Substrat 112 verbunden und dementsprechend lokalisiert bleibt, bis das erste Substrat 112 an das zweite Substrat 108 gebondet wird.

Nach dem Bonden dieser Konfiguration des ersten Substrats 112 mit einem zweiten Substrat und nach dem Materialabtragungsschritt bildet die Insel 130 eine isolierte Struktur innerhalb der Vertiefung mit einer genau definierten Position. Diese Position ergibt sich aus der Verbindung zum ersten Substrat 112 über die Brücken 132 während des Bondingschritts.

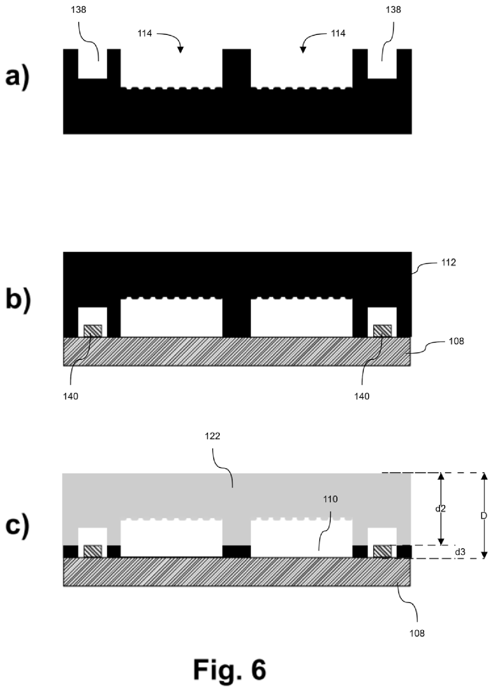

Figur 6 zeigt verschiedene Stadien eines Herstellungsprozesses für ein strukturiertes Glasbauteil unter Verwendung von Abstandshaltern.

In Figur 6a ist ein erstes Substrat 112 mit einem Tiefenprofil 114 dargestellt. Das Tiefenprofil 114 bildet Vertiefungen oder Kanäle innerhalb des ersten Substrats 112. Auf beiden Seiten des Tiefenprofils 114 befinden sich erhöhte Bereiche, die als Ausnehmungen 138 bezeichnet werden.

Figur 6b zeigt den nächsten Schritt des Prozesses, bei dem das erste Substrat 112 mit einem zweiten Glassubstrat 108 entlang sener ersten Oberfläche 116 verbunden wurde. Das zweite Glassubstrat 108 ist als schraffierter Bereich am unteren Rand der Struktur dargestellt. Das Tiefenprofil 114 aus Figur 6a ist nun zwischen den beiden Substraten eingeschlossen und bildet interne Kanäle. Abstandshalter 140 sind auf beiden Seiten der Struktur zwischen dem ersten Substrat 112 und dem zweiten Glassubstrat 108 positioniert. Die Abstandshalter 140 befinden sich innerhalb der Ausnehmungen 138 des ersten Substrats 112.

Figur 6c stellt die finale Phase des Herstellungsprozesses zur Erzeugung der Vertiefungen dar. Ein Materialabtrag 122 wurde an der Oberseite des ersten Substrats 112 durchgeführt, wodurch die zuvor eingeschlossenen Kanäle freigelegt werden. Dies erzeugt offene Vertiefungen 110 in der Glasstruktur. Das zweite Glassubstrat 108 bleibt am Boden intakt und bildet einen glatten Boden für die nun freigelegten Kanäle. Die Abstandshalter 140 sind weiterhin an den Seiten sichtbar, können aber vor der weiteren Verwendung des erzeugten Artikels zur Herstellung eines mikrofluidischen Bauteils entfernt werden.

Die Tiefe des Materialabtrags ist in der Figur 6c als d2 gekennzeichnet, während die Dicke der Abstandshalter als d3 bezeichnet wird. Die Summe der Tiefe des Materialabtrags d2 und der Dicke der Abstandshalter d3 ergibt dabei die Dicke D des ersten Substrats 112. Diese Dimensionen veranschaulichen die Präzision des Herstellungsprozesses und die Möglichkeit, die endgültige Geometrie des strukturierten Glasbauteils zu kontrollieren. Die Abstandshalter 140 haben eine höhere Härte als das Material des ersten Substrats 112 und begrenzen somit die Tiefe des Materialabtrags.

Die Dicke d3 der Abstandshalter 140 kann dementsprechend verwendet werden, um die Tiefe der Kanäle zu definieren. Durch die Wahl der Dicke d3 der Abstandshalter 140 kann die endgültige Tiefe der Vertiefungen 110 präzise eingestellt werden. Dies ermöglicht eine genaue Kontrolle über die Geometrie der mikrofluidischen Kanäle im fertigen Glasbauteil.

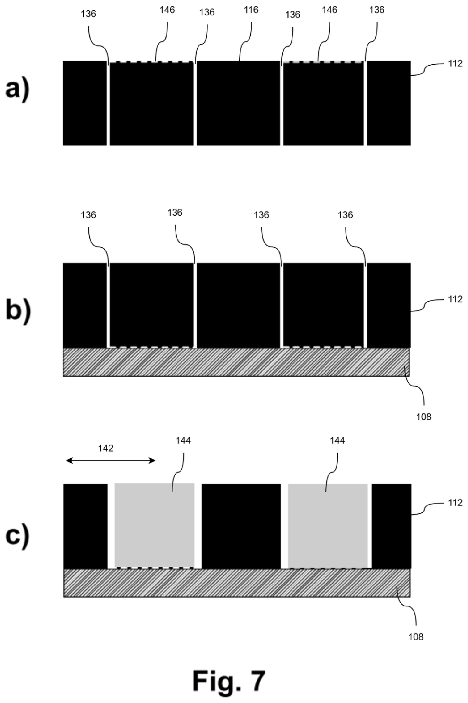

Fig. 7 zeigt drei Querschnittsansichten eines strukturierten Glasbauteils, die verschiedene Stadien eines weiteren beispielhaften Herstellungsprozesses darstellen.

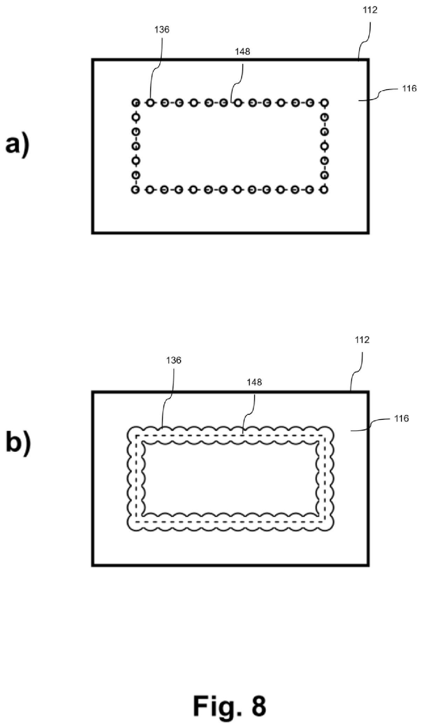

In Fig. 7a ist ein erstes Substrat 112 mit einer ersten Oberfläche 116 dargestellt. Das erste Substrat 112 weist mehrere Filamente 136 auf, die sich vertikal von der ersten Oberfläche 116 durch das erste Substrat 112 erstrecken. Die Filamente 136 verlaufen dabei entlang einer Konturlinie, sind jedoch nicht miteiannder verbunden, bilden als keine geschlossene Kurve bzw. keinen Schnittspalt. Hierzu wird im Folgenden noch mit Bezug auf Figur 8 eingegangen. Die Filamente 136 definieren Bereiche 146, deren Oberflächen so bearbeitet sind, dass eine Verbindung mit einem zweiten Glassubstrat 108 verhindert wird. Diese Bearbeitung kann beispielsweise durch Aufrauen, geringfügigen Glasabtrag oder eine hydrophobe Beschichtung erfolgen.

Fig. 7b zeigt das erste Substrat 112 verbunden mit einem zweiten Glassubstrat 108. Die Verbindung kann durch Fusionsbonden, direktes Bonden, anodisches Bonden, Laserschweißen oder Kleben erfolgen. In den Bereichen 146 wird die Verbindung zwischen dem ersten Substrat 112 und dem zweiten Glassubstrat 108 verhindert.

In Fig. 7c sind Segmente 144 im ersten Substrat 112 durch Verbreiterung der Filamente 136 entlang der Erstreckungsrichtung 142 des ersten Substrats 112 mittels Ätzen erzeugt worden. Diese Segmente 144 sind nicht mehr mit dem ersten Substrat 112 oder dem zweiten Glassubstrat 108 verbunden und können herausfallen, da durch eine Verbreiterung der Filamente 136 entlang der Erstreckungsrichtung 142 des ersten Substrats eine geschlossene Kurve bzw. ein durchgängiger Schnittspalt erzeugt wurde, sodass die Segmente 144 von dem Material des ersten Substrats 112 getrennt wurden.

Dieses Verfahren ermöglicht die Herstellung von strukturierten Glasbauteilen mit präzise geformten internen Kanälen oder Hohlräumen ohne den zuvor beschriebenen abschließenden Materialabtrag. Die Möglichkeit, Filamente 136 und Segmente 144 innerhalb des Glassubstrats zu erzeugen und zu manipulieren, bietet ein hohes Maß an Kontrolle über die interne Geometrie der endgültigen Struktur.

Fig. 8 zeigt eine Draufsicht auf ein strukturiertes Glasbauteil. In Fig. 8a ist ein erstes Substrat 112 mit einer ersten Oberfläche 116 dargestellt. Innerhalb des ersten Substrats 112 sind mehrere Filamente 136 angeordnet, die als kleine Kreise in einem rechteckigen Muster sichtbar sind. Eine Konturlinie 148 umgibt die Anordnung der Filamente 136 und definiert die Grenzen des strukturierten Bereichs. In dieser Konfiguration sind die Filamente 136 zwar bereits entlang der Konturlinie angeordnet, überlappen jedoch nicht und bilden somit keinen durchgängigen Schnittspalt, sodass der durch die Filamente 136 umschriebene Bereich weiterhin mit dem Rest des Substrats 112 verbunden ist.

Fig. 8b zeigt eine modifizierte Version der Struktur aus Fig. 8a nach einem Ätzschritt zur Verbreiterung der Filamente 136. Das erste Substrat 112 und die erste Oberfläche 116 bleiben unverändert. Die Filamente 136 sind nun miteinander verbunden und bilden eine durchgehende Linie entlang der Konturlinie 148.

Dadurch entsteht ein Schnittspalt entlang der Konturlinie 148, sodass der durch die Filamente 136 umschriebene Bereich des ersten Substrats 112 nicht mehr mit dem ersten Substrat 112 verbunden ist und aus diesem herausgelöst werden kann. Diese Methode ermöglicht die Erzeugung präziser interner Geometrien innerhalb des ersten Substrats 112. Die Filamente 136 können in einem regelmäßigen Gittermuster angeordnet werden, was eine kontrollierte Strukturierung innerhalb des ersten Substrats 112 ermöglicht.

Durch die Verbreiterung der Filamente 136 mittels Ätzen können definierte Kanäle oder Hohlräume mit präzisen Grenzen geschaffen werden, wie durch die Konturlinie 148 angezeigt. Gleichzeitig bleibt die Integrität des umgebenden Glasmaterials erhalten. Diese Technik kann zur Herstellung von Mikrofluidik-Bauteilen oder anderen spezialisierten Glasstrukturen mit komplexen internen Geometrien verwendet werden.

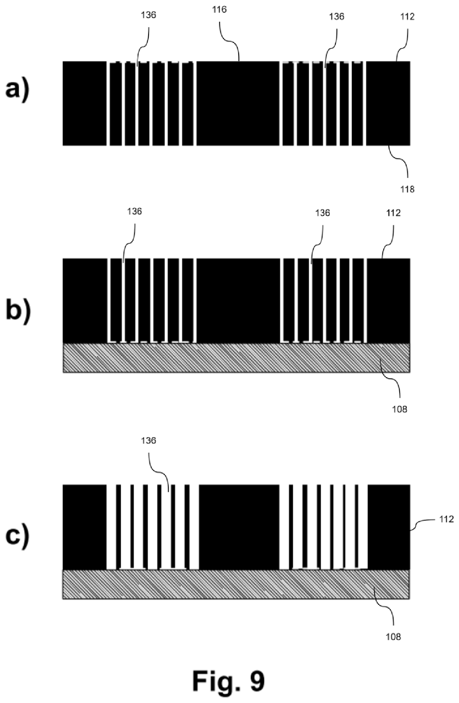

Ein alternatives Herstellungsverfahren, das ebenfalls keinen abschließenden Materialabtragungsschritt erfordert, wird nun mit Bezug auf Fig. 9 beschrieben.

Fig. 9 zeigt drei Schnittansichten eines strukturierten Glasbauteils in verschiedenen Herstellungsstadien. In Ansicht a) ist ein erstes Substrat 112 mit einer ersten Oberfläche 116 dargestellt. Mehrere Filamente 136 erstrecken sich vertikal von der ersten Oberfläche 116 durch das erste Substrat 112 hindurch. Die Filamente 136 sind in zwei Gruppen angeordnet, die durch einen breiteren Spalt in der Mitte getrennt sind.

In Ansicht b) wird ein zweites Glassubstrat 108 auf das erste Substrat 112 und die Filamente 136 gebondet. Das zweite Glassubstrat 108 kann strukturiert oder unstrukturiert sein. Das zweite Glassubstrat 108 weist eine flache Bodenfläche auf, die mit den oberen Enden der Filamente 136 und der ersten Oberfläche 116 des ersten Substrats 112 in Kontakt steht.

Ansicht c) zeigt das Endergebnis des Herstellungsprozesses. Die Struktur ähnelt der in Ansicht b), jedoch wurden die Zwischenräume zwischen den Filamenten 136 durch einen Ätzprozess erweitert. Diese Erweiterung erzeugt breitere Kanäle oder Hohlräume innerhalb des Glasbauteils.

Das erste Substrat 112 und das zweite Glassubstrat 108 können aus Borosilikatglas hergestellt sein. Durch die Erweiterung der Filamente 136 entstehen Seitenwände, die makroskopisch glatt/gerade sein können und in einem definierten Winkel, vorzugsweise senkrecht, auf den Boden treffen.

Dieses Verfahren ermöglicht die Herstellung strukturierter Glasbauteile mit internen Kanälen, die präzise geformt und modifiziert werden können, ohne dass ein abschließender Materialabtragungsschritt erforderlich ist.

Merkmale der oben beschriebenen Beispiele oder Ausführungsformen können kombiniert werden, um zusätzliche Beispiele oder Ausführungsformen zu erstellen, ohne die beabsichtigte Wirkung zu verlieren. Es sollte verstanden werden, dass die oben gegebene Beschreibung einer Ausführungsform oder eines Beispiels nur beispielhaft ist und verschiedene Modifikationen von einem Fachmann vorgenommen werden könnten. Darüber hinaus wird ein Fachmann erkennen, dass zahlreiche weitere Modifikationen und Kombinationen verschiedener Aspekte möglich sind. Dementsprechend sollen die beschriebenen Aspekte alle solche Änderungen, Modifikationen und Variationen umfassen, die in den Rahmen der beigefügten Ansprüche fallen.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 100: Glassubstrat
- 102: Kanal
- 104: Seitenwand
- 106: Bodenfläche
- 108: zweites Glassubstrat
- 110: Vertiefung
- 112: erstes Substrat
- 114: Tiefenprofil
- 116: erste Oberfläche
- 118: zweite Oberfläche
- 120: Oberfläche
- 122: Materialabtrag
- 124: Bodenfläche
- 126: Laser
- 128: Fräskopf
- 130: Insel
- 132: erster Teilbereich
- 134: zweiter Teilbereich
- 136: Filament
- 138: Ausnehmung
- 140: Abstandshalter
- 142: Erstreckungsrichtung
- 144: Segment
- 146: Bereich
- 148: Konturlinie
- 150: Ätzschritt

## Patentansprüche

1. Verfahren zur Herstellung eines strukturierten Glasartikels mit wenigstens einer die Struktur bildenden einseitig offenen Vertiefung (110), wobei die Vertiefung Seitenwände (104) und eine Bodenfläche (106) aufweist, wobei das Verfahren folgende Schritte aufweist:
- Vorstrukturieren eines ersten Substrats (112) aus Glas, sodass in dem Substrat ein Tiefenprofil (114) ausgebildet wird, das sich von einer ersten Oberfläche (116) des Substrats in Richtung einer zweiten Oberfläche (118) des Substrats erstreckt,
- Stoffschlüssiges Verbinden der ersten Oberfläche (116) des ersten Substrats (112) mit einer Oberfläche (120) eines zweiten Substrats (108), wobei die Oberfläche (120) des zweiten Substrats (108) wenigstens in demjenigen Bereich, der mit dem Tiefenprofil (114) in der ersten Oberfläche (116) des ersten Substrats (112) überlappt, einen quadratischen Mittenrauwert Rq von < 5 nm aufweist,
- Nachbearbeiten des ersten Substrats (112) zur Erzeugung der wenigstens einen Vertiefung (110), sodass die Bodenfläche (106) der Vertiefung (110) durch die Oberfläche (120) des zweiten Substrats (108) gebildet wird.

2. Verfahren nach Anspruch 1, **dadurch gekennzeichnet, dass** das erste Substrat (112) eine Dicke D aufweist, wobei sich das Tiefenprofil (114) höchstens bis in eine Tiefe d1 in das Substrat (112) hinein erstreckt, wobei d1 < D gilt.

3. Verfahren nach Anspruch 1, **dadurch gekennzeichnet, dass** das erste Substrat (112) eine Dicke D aufweist, wobei sich das Tiefenprofil (114) in einem ersten Teilbereich (132) bis in eine Tiefe d1 in das erste Substrat (112) hinein erstreckt, wobei d1 < D gilt und wobei sich das Tiefenprofil (114) in einem zweiten Teilbereich (134) vollständig durch das Substrat (112) erstreckt.

4. Verfahren nach Anspruch 2 oder 3, **dadurch gekennzeichnet, dass** das Nachbearbeiten des ersten Substrats (112) das Abtragen von Material von dem ersten Substrat (112) über eine Dicke d2 von der zweiten Oberfläche (118) ausgehend beinhaltet, wobei d2 > D - d1 gilt.

5. Verfahren nach Anspruch 4, **dadurch gekennzeichnet, dass** vor dem Abtragen von Material von dem ersten Substrat (112) wenigstens ein Abstandshalter (140) auf die dem ersten Substrat (112) zugewandte Oberfläche (120) des zweiten Substrats (108) im Bereich des Tiefenprofils (114) aufgebracht werden, wobei der Abstandshalter (140) eine Dicke d3 = D - d2 aufweist und wobei der Abstandshalter (140) aus einem Material besteht, dessen Härte größer ist als die Härte des ersten Substrats (112).

6. Verfahren nach einem der vorherigen Ansprüche, **dadurch gekennzeichnet, dass** das Tiefenprofil (114) durch Laserablation erzeugt wird.

7. Verfahren nach einem der Ansprüche 1 bis 5, **dadurch gekennzeichnet, dass** das Tiefenprofil (114) durch spanende Bearbeitung des ersten Substrats (112) erzeugt wird.

8. Verfahren nach einem der Ansprüche 1 bis 5, **dadurch gekennzeichnet, dass** das Tiefenprofil (114) durch Einbringen von Filamenten (136) in den Glaskörper des ersten Substrats (112) und eine anschließende Verbreiterung der Filamente (136) senkrecht zur Erstreckungsrichtung der Filamente (136) erzeugt wird.

9. Verfahren nach Anspruch 1, **dadurch gekennzeichnet, dass** sich das Tiefenprofil (114) durch das Substrat (112) hindurch erstreckt und wobei das Tiefenprofil (114) in der Oberfläche des Substrats (112) keine geschlossene Kurve bildet, die einen Teilbereich der Oberfläche vollständig einschließt.

10. Verfahren nach Anspruch 9, **dadurch gekennzeichnet, dass** das Nachbearbeiten des ersten Substrats (112) das Erhöhen der Ausdehnung des Tiefenprofils (114) in Erstreckungsrichtung (142) des Substrats (112) beinhaltet.

11. Verfahren nach Anspruch 9 oder 10, **dadurch gekennzeichnet, dass** das Tiefenprofil (114) aus Filamenten (136) besteht, wobei die Filamente (136) nicht miteinander überlappen.

12. Verfahren nach Anspruch 11, **dadurch gekennzeichnet, dass** die Filamente (136) entlang einer Konturlinie (148) angeordnet sind, wobei das Nachbearbeiten das Erhöhen des Durchmessers der Filamente (136) beinhaltet, sodass sich benachbarte Filamente (136) zu einem durchgehenden Schnittspalt verbinden, der sich entlang der Konturlinie (148) erstreckt.

13. Verfahren nach Anspruch 11, **dadurch gekennzeichnet, dass** die Filamente (136) in einer Teilfläche der Oberfläche des Substrats (112) in einem regelmäßigen oder unregelmäßigen Muster flächig eingebracht werden, wobei das Nachbearbeiten das Erhöhen des Durchmessers der Filamente (136) beinhaltet, sodass sich benachbarte Filamente (136) zu einer flächigen Ausnehmung aus dem ersten Substrat (112) verbinden.

14. Verfahren nach einem der Ansprüche 9 bis 13, **dadurch gekennzeichnet, dass** nach dem Vorstrukturieren des ersten Substrats (112) und vor dem Verbinden der ersten Oberfläche (116) des ersten Substrats (112) mit der Oberfläche (120) des zweiten Substrats (108) definierte Bereiche (146) der ersten Oberfläche (116) des ersten Substrats (112) so bearbeitet werden, dass ein stoffschlüssiges Verbinden des ersten Substrats (112) mit dem zweiten Substrat (108) in den definierten Bereichen (146) verhindert wird.

15. Strukturierter Glasartikel hergestellt nach dem Verfahren nach einem der vorhergehenden Ansprüche.

16. Strukturierter Glasartikel nach Anspruch 15, **dadurch gekennzeichnet, dass** die Seitenwände (104) des Tiefenprofils (114) in dem ersten Substrat (112) eine Rauheit Rq von mehr als 100 nm aufweisen.
